# EUROPÄISCHE PATENTSCHRIFT

(11) **EP 0 569 715 B1**
(45) Veröffentlichungstag und Bekanntmachung des Hinweises auf die Patenterteilung: **14.08.1996**
(21) Anmeldenummer: 93105935.6
(22) Anmeldetag: 13.04.1993
(51) Int. Cl.: C04B 35/00, H01B 12/02, H01L 39/24, B28B 21/30, B22D 13/02

(54) **Verfahren zur Herstellung rohrförmiger Formteile aus Hochtemperatur-Supraleiter-Material**
Process for the production of tube shaped mouldings out of high temperature superconductor material
Procédé de production de pièces moulées tubulaires d'un matériau supraconducteur à haute température

(30) Priorität: 09.05.1992 DE 4215289
(43) Veröffentlichungstag der Anmeldung: 18.11.1993
(73) Patentinhaber: HOECHST AKTIENGESELLSCHAFT, 65926 Frankfurt am Main (DE)
(72) Erfinder: Preisler, Eberhard, Dr., W-5042 Erftstadt-Liblar (DE); Bock, Joachim, Dr., W-5042 Erftstadt (DE)

(56) Entgegenhaltungen:
- DE-A- 4 019 368

## Beschreibung

Die vorliegende Erfindung betrifft ein Verfahren zur Herstellung rohrförmiger Formteile aus Hochtemperatur-Supraleiter-Material auf der Basis von Oxiden des Bismuts, Calciums, Strontiums, Kupfers und gegebenenfalls des Bleis, wobei man eine homogene Schmelze des Oxidgemisches in vorgegebener Stöchiometrie herstellt, und wobei man die Schmelze mit Temperaturen von 900 bis 1300°C in eine Gießzone einlaufen läßt, welche in Abhängigkeit von ihrer lichten Weite mit 200 bis 1500 Upm um ihre Achse rotiert, und wobei man das erstarrte Formteil aus der Gießzone entnimmt, und wobei man das Formteil 4 bis 150 Stunden bei 700 bis 900°C in sauerstoffenthaltender Atmosphäre tempert.

Aus der DE-OS 40 19 368 ist ein Verfahren zur Herstellung rohrförmiger Teile aus Hochtemperatur-Supraleiter-Material auf der Basis der Oxide des Bismuts, Calciums, Strontiums und Kupfers bekannt, bei welchem man eine homogene Schmelze des Oxidgemisches mit Temperaturen von 900 bis 1100°C in eine um ihre waagerechte Achse rotierende Gießzone einlaufen und darin erstarren läßt. Das aus der Gießzone entnommene erstarrte Formteil tempert man anschließend bei Temperaturen von 700 bis 900°C 4 bis 150 Stunden lang in sauerstoffenthaltender Atmosphäre.

Führt man Tieftemperatur-Supraleiter-Systemen, insbesondere Spulen, welche bei 4 K mit Flüssighelium-Kühlung betrieben werden müssen, elektrischen Strom über Kupferleiter zu, so wird einerseits Wärme über das Temperaturgefälle zwischen 300 K und 4 K und andererseits über den elektrischen Widerstand des Kupfers Joulesche Wärme in den Flüssighelium-Vorrat transportiert, wodurch eine unerwünschte Helium-Verdampfung erfolgt.

Führt man nun den elektrischen Strom anstatt durch einen Kupferleiter durch einen keramischen Hochtemperatur-Supraleiter zu, so verringert sich der Wärmezufluß zum Flüssighelium-Vorrat erheblich; und zwar einerseits durch die geringere Wärmeleitfähigkeit des Hochtemperatur-Supraleiters im Vergleich zum gut wärmeleitenden Kupfer und andererseits durch den Wegfall der Entwicklung von Joulescher Wärme, da im Temperaturbereich unterhalb der Sprungtemperatur des Hochtemperatur-Supraleiters Strom widerstandsfrei transportiert wird.

Wegen des durch den eigenen Strom erzeugten Magnetfeldes im Leiter, des sog. magnetischen Eigenfeldeffektes, ist es günstiger, anstelle von stabförmigen Stromzuführungen solche in Rohrform zu verwenden, da wegen der Verteilung des stromtragenden Querschnitts über eine größere Fläche das Eigenmagnetfeld und damit auch der negative Einfluß auf das Stromtragevermögen des Leiters kleiner wird.

Die dem Flüssighelium-Vorrat zugeführte Wärmemenge wird durch den Querschnitt der Stromzuführung aus Hochtemperatur-Supraleiter-Material bestimmt. Dabei ist zu berücksichtigen, daß zum Transportieren eines bestimmten Stromes durch einen Hochtemperatur-Supraleiter ein gewisser Mindestquerschnitt erforderlich ist. Das aus der Schmelze der Oxide von Bismut, Calcium, Strontium, Kupfer und gegebenenfalls Blei erhaltene Hochtemperatur-Supraleiter-Material weist dabei den Vorzug auf, daß sein Stromtragevermögen bei 4 K um etwa das 50- bis 100-fache größer ist als bei 77 K, d.h. daß der Materialquerschnitt bei der niedrigeren Temperatur im Bereich der Heliumkühlung weit überdimensioniert ist. Daher wäre es von Vorteil, die Stromzuführung über den Hochtemperatur-Supraleiter so auszulegen, daß der stromführende Querschnitt des "kalten" Endes (4 K) nur 10 bis 20 % des Querschnittes am "warmen" Ende (77 K) betragen würde.

Es ist daher Aufgabe der vorliegenden Erfindung, ein Verfahren zur Herstellung solcher rohrförmiger Teile aus Hochtemperatur-Supraleiter-Material auf der Basis von Oxiden des Bismuts, Calciums, Strontiums, Kupfers und gegebenenfalls des Bleis anzugeben, deren Querschnitte an ihren beiden Enden beträchtlich voneinander verschieden sind. Das wird erfindungsgemäß dadurch erreicht, daß man eine homogene Schmelze des Oxidgemisches mit Temperaturen von 900 bis 1300°C in eine Gießzone einlaufen läßt, welche in Abhängigkeit von ihrer lichten Weite mit 200 bis 1500 Upm rotiert, wobei die Achse der Gießzone um mindestens 15° gegenüber der Horizontalen geneigt ist, und wobei man anschließend das aus der Gießzone entnommene erstarrte Formteil bei Temperaturen von 700 bis 900°C in sauerstoffenthaltender Atmosphäre tempert.

Das Verfahren gemäß der Erfindung kann weiterhin wahlweise auch noch dadurch ausgestaltet sein, daß
a) die Achse um bis zu 90° gegenüber der Horizontalen geneigt ist;
b) die Achse um 20 bis 60° gegenüber der Horizontalen geneigt ist;
c) die Gießzone eine Kokille mit zylindrischem Innenraum ist;
d) die Gießzone eine Kokille mit konusförmigem Innenraum ist;
e) größeren Neigungen der rotierenden Kokille gegenüber der Horizontalen größere Zahlen ihrer Umdrehung zugeordnet sind und umgekehrt.

In der beigefügten Zeichnung sind eine Schleudergußapparatur sowie nach dem erfindungsgemäßen Verfahren erhaltene rohrförmige Formkörper schematisch und im Schnitt dargestellt. Dabei zeigen:
- Fig. 1: Eine Schleudergußapparatur mit waagerecht angeordneter rotierender Achse, auf die die Kokille aufgeschoben ist;
- Fig. 2: in einer zylinderförmigen Kokille erhaltene Formkörper;
- Fig. 3: eine waagerecht angeordnete konusförmige Kokille mit Formkörper;
- Fig. 4: in einer konusförmigen Kokille erhaltene Formkörper;
- Fig. 5: eine senkrecht angeordnete zylindrische Kokille mit Formkörper.

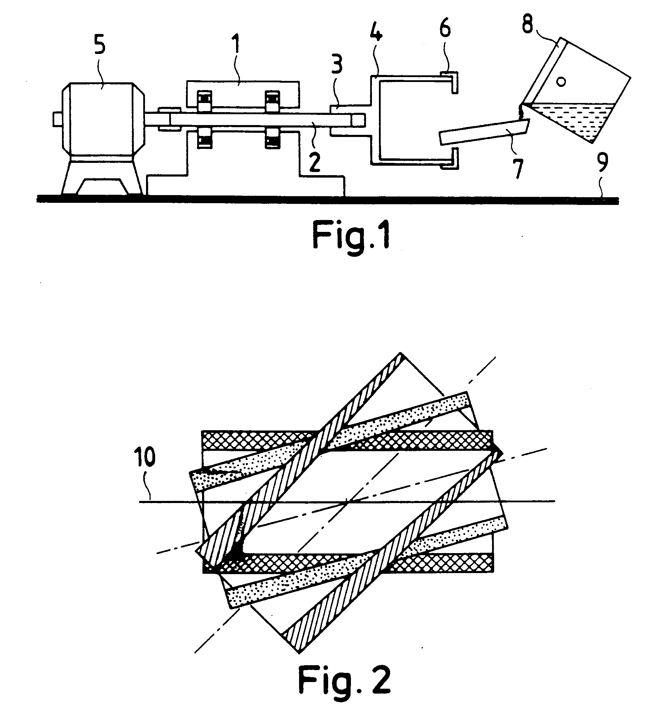

Nach Fig. 1 sind auf einer kippbar angeordneten Bodenplatte 9 ein Achsenlager 1 und ein drehzahlregelbarer Elektromotor 5 befestigt. Auf das eine Ende einer im Achsenlager 1 befindlichen Welle 2 ist der Fortsatz 3 einer Kokille 4 aufgeschoben, während das andere Ende der Welle 2 mit dem Elektromotor 5 kraftschlüssig verbunden ist. Auf das offene Ende der Kokille 4 ist ein Abschlußring 6 aufgeschoben. In das offene Ende der Kokille 4 ragt eine Gießrinne 7 hinein, welche aus einem Tiegel 8 mit Schmelze beaufschlagbar ist.
In Figur 2 sind Formkörper wiedergegeben, welche unter verschiedenen Kippwinkeln gegenüber der Horizontalen 10 erhalten wurden.

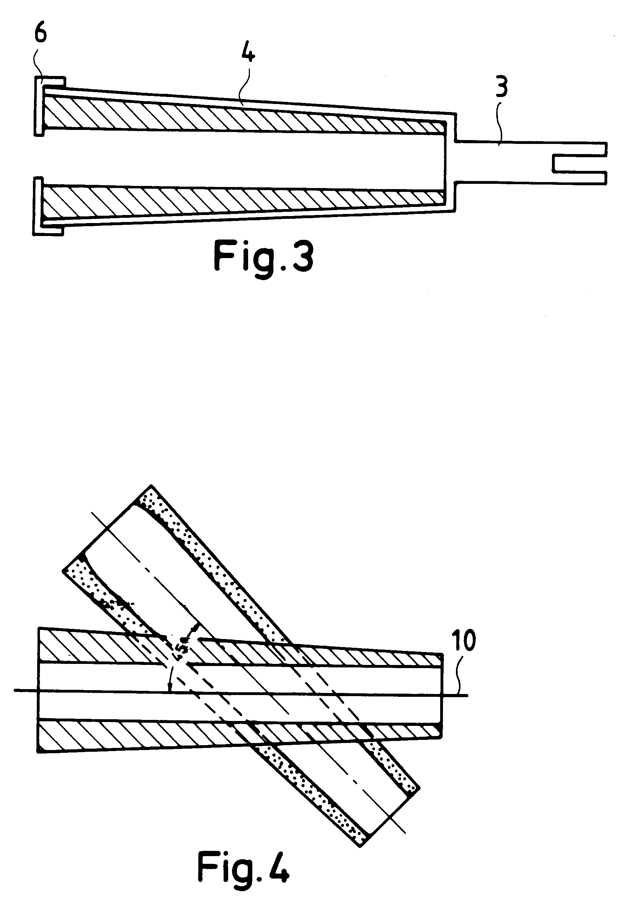

Fig. 3 zeigt eine konusförmige Kokille 4 mit Fortsatz 3, auf die ein Abschlußring 6 aufgeschoben ist.

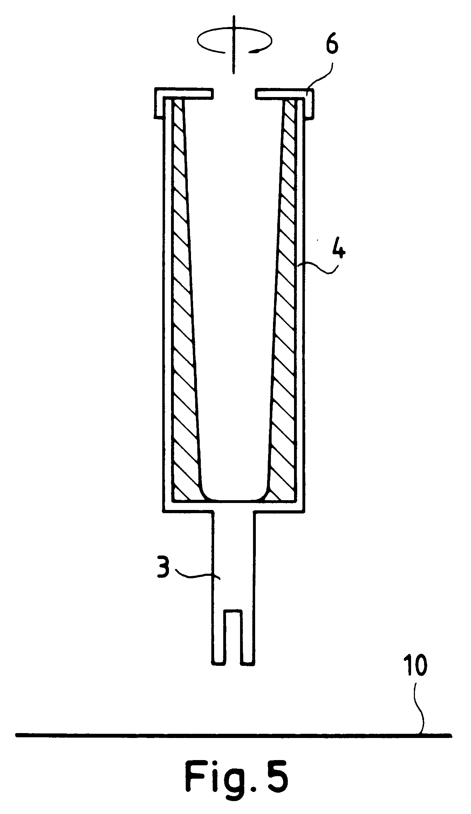

In Fig. 4 sind zwei Formkörper wiedergegeben, welche in einer Kokille nach Fig. 3 erhalten wurden, wobei der eine Formkörper bei in der Horizontale 10 angeordneter Kokille und der andere bei um 45° gekippter Kokille erhalten wurde. Fig. 5 zeigt eine zylindrische Kokille 4 mit Fortsatz 3, deren Achse während des Gießens senkrecht zur Horizontalen 10 rotiert, wobei auf die offene Seite der Kokille 4 ein Abschlußring 6 aufgeschoben ist.

Beim Verfahren gemäß der Erfindung kommt, wenn man die Drehachse der Kokille um einen bestimmten Winkel aus der Horizontalen anhebt, neben der Zentrifugalbeschleunigung durch die Rotation der Kokille noch die Schwerkraft zur Wirkung, welche je nach Achsenneigung die noch flüssige Schmelze in den tiefer gelegenen Bereich der Kokille fließen läßt. Durch die Variation von Schmelzemenge, Drehzahl der Kokille und ihrem Winkel gegenüber der Horizontalen können Rohre gegossen werden, deren Querschnitt sich an ihrem oberen und unteren Ende um einen Faktor von 3 bis 4 unterscheiden (vgl. Fig. 2).

Mit dem erfindungsgemäßen Verfahren lassen sich noch größere Unterschiede im Querschnitt zwischen dem oberen und unteren Ende der Formkörper dadurch erreichen, daß man eine kegelstumpfförmige Kokille 4 verwendet (vgl. Fig. 3). Dabei hängt die Querschnittsverminderung von der Geometrie der Kokille und ihrem Befüllungsgrad ab.

Während bei Verwendung einer konischen Kokille in horizontaler Anordnung nach dem Stand der Technik die Wandstärke zum "schlankeren" Ende hin abnimmt, kann man erfindungsgemäß durch Neigung der Achse der konischen Kokille gegen die Horizontale eine nahezu gleichmäßige Kegelwandstärke erreichen, weil in diesem Falle die Schmelze durch die Schwerkraft nach unten gezogen wird, während die Zentrifugalbeschleunigung die Schmelze entlang der Mantelfläche zum offenen Ende hin drückt (vgl. Fig. 4).

Beim Verfahren gemäß der Erfindung ist jeder Neigung der Achse der rotierenden Gießzone eine spezielle Umdrehungszahl der Gießzone je Zeiteinheit zuzuordnen, welche von weiteren Parametern (Länge, Form und freier Querschnitt der Gießzone, Viskosität der Schmelze etc.) abhängig ist, wodurch die auf die in die Gießzone eingetragene Schmelze einwirkenden gegenläufigen Kräfte (Zentrifugalbeschleunigung, Erdanziehung) etwa ausgeglichen werden.

Beim erfindungsgemäßen Verfahren werden bei Neigungswinkeln zwischen 15 und 80° bei Verwendung einer zylindrischen Kokille Formkörper erhalten, welche außen zylindrisch und innen konisch gestaltet sind; bei einem Neigungswinkel von 90° gegenüber der Horizontalen weist der resultierende Formkörper innen parabolische Form auf (vgl. Fig. 5).

Bei den folgenden Beispielen wurde ein Hochtemperatur-Supraleiter der Zusammensetzung Bi₂Sr₂CaCu₂O₈₊ₓ (mit x = 0 bis 0,3) hergestellt. Bei entsprechender Änderung der Zusammensetzung sowie Anpassung der Vor- und Nachbehandlungsparameter lassen sich jedoch auch andere schmelzbare Hochtemperatur-Supraleiter auf Bismutbasis auf analoge Weise herstellen.

### Beispiel 1 (nach dem Stand der Technik)

400 g eines Gemisches aus den Oxiden des Bismuts, Strontiums, Calciums und Kupfers im molaren Verhältnis der Metalle von 2 : 2 : 1 : 2 wurden in einem Sinterkorundtiegel bei 1050°C aufgeschmolzen. Eine zylindrische Kokille 4 (Innendurchmesser: 47 mm, Länge: 100 mm) war auf die mit dem Elektromotor 5 kraftschlüssig verbundene Welle 2 aufgeschoben und mit einem Abschlußring 6 versehen (vgl. Fig. 1), wobei die Achse der Kokille 4 horizontal verlief (Anstellwinkel: 0°) Als die Kokille 4 mit 750 Upm rotierte, wurde die Schmelze aus dem Tiegel 8 über die Gießrinne 7 in die Kokille 4 abgegossen. Nach Erstarrung der Schmelze wurde das zylindrische Formteil aus der Kokille entnommen und 100 Stunden bei 840°C getempert. Die Querschnittsflächen des supraleitenden Formkörpers waren an seinen beiden Enden etwa gleich groß (vgl. Fig. 2 und Tabelle 1).

### Beispiel 2 (gemäß der Erfindung)

Beispiel 1 wurde mit der Änderung wiederholt, daß einerseits die Achse der Kokille gegenüber der Horizontale gekippt wurde (Anstellwinkel: 20°, 45° und 90°) und daß andererseits höhere Rotationsgeschwindigkeiten der Kokille angewendet wurden.
Die Querschnittsflächen der supraleitenden Formkörper waren an ihren beiden Enden voneinander verschieden (vgl. Fig. 2 und Tabelle 1).

### Beispiel 3 (gemäß der Erfindung)

Die Beispiele 1 und 2 wurden mit der Änderung wiederholt, daß eine zylindrische Kokille mit einem Innendurchmesser von 35 mm verwendet wurde und daß Drehzahlen für die Kokille von 1000 bis 1400 Upm angewendet wurden.

Die Dimensionen der supraleitenden Formkörper sind in Tabelle 2 angegeben.

### Beispiel 4 (gemäß der Erfindung)

In Anlehnung an Beispiel 1 wurde eine konische Kokille 4, deren eines Ende einen Innendurchmesser von 45 mm und deren anderes Ende einen Innendurchmesser von 25 mm bei einer Länge von 150 mm aufwies, auf die mit dem Elektromotor 5 kraftschlüssig verbundene Welle 2 aufgeschoben.

Die variierenden Einwaagen des Oxidgemisches, die verschiedenen Drehzahlen für die konische Kokille sowie die unterschiedlichen Anstellwinkel ihrer Achse sind der Tabelle 3 zu entnehmen.

**Tabelle 1**

| Zylinderförmige Hohlkörper mit 47 mm Außendurchmesser | | | | | |
|---|---|---|---|---|---|
| Beispiel | 1 | 2a | 2b | 2c | 2d |
| Drehzahl [Upm] | 750 | 750 | 750 | 850 | 1050 |
| Anstellwinkel [Grad] | 0 | 20 | 45 | 45 | 90 |
| Du [mm] | 5,84 | 7,02 | 7,67 | 9,18 | 10,60 |
| Do [mm] | 5,60 | 5,34 | 3,40 | 3,78 | 6,03 |
| Fu [cm²] | 8,10 | 9,48 | 10,20 | 11,77 | 13,12 |
| Fo [cm²] | 7,81 | 7,49 | 4,98 | 5,49 | 6,03 |
| Fo / Fu | 0,96 | 0,79 | 0,49 | 0,47 | 0,46 |
| Gewicht [g] | 400 | 443 | 360 | 437 | 421 |
| Erläuterung: Du = Wanddicke unten Do = Wanddicke oben Fu = Stirnfläche unten Fo = Stirnfläche oben | | | | | |

**Tabelle 2**

| Zylinderförmige Hohlkörper mit 35 mm Außendurchmesser | | | | | |
|---|---|---|---|---|---|
| Beispiel | 3a | 3b | 3c | 3d | 3e |
| Drehzahl [Upm] | 1000 | 1350 | 1350 | 1100 | 1400 |
| Anstellwinkel [Grad] | 0 | 20 | 45 | 90 | 90 |
| Du [mm] | 4,01 | 5,49 | 6,70 | 8,80 | 7,31 |
| Do [mm] | 3,98 | 2,68 | 2,20 | 2,60 | 2,41 |
| Fu [cm²] | 3,90 | 5,42 | 5,96 | 7,24 | 6,36 |
| Fo [cm²] | 3,86 | 2,68 | 2,27 | 2,65 | 2,41 |
| Fo / Fu | 0,99 | 0,49 | 0,38 | 0,37 | 0,38 |
| Länge [mm] | 200 | 200 | 170 | 137 | 139 |
| Gewicht [g] | *) | 443 | 385 | 371 | 335 |
| Erläuterung: Du = Wanddicke unten Do = Wanddicke oben Fu = Stirnfläche unten Fo = Stirnfläche oben | | | | | |

| | | | | | |
|---|---|---|---|---|---|
| *) nicht bestimmt | | | | | |

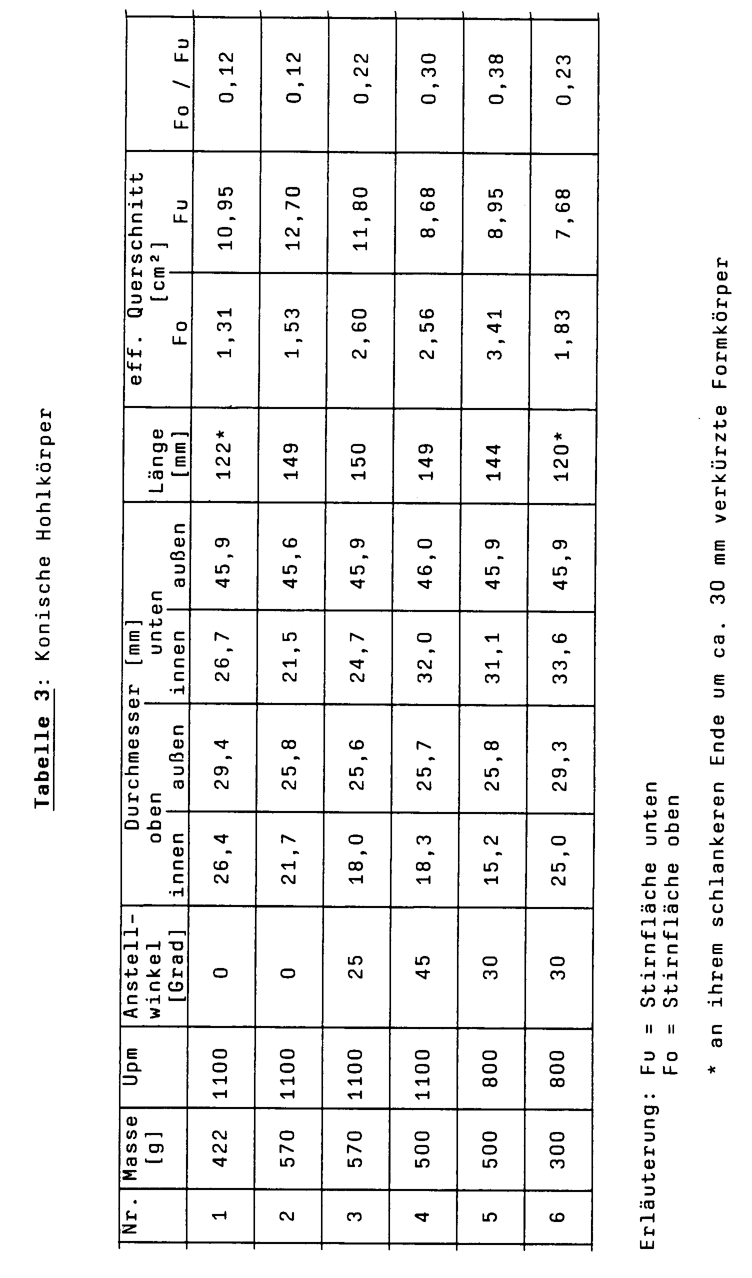

## Patentansprüche

1. Verfahren zur Herstellung rohrförmiger Formteile aus Hochtemperatur-Supraleiter-Material auf der Basis von Oxiden des Bismuts, Calciums, Strontiums, Kupfers und gegebenenfalls des Bleis, wobei man eine homogene Schmelze des Oxidgemisches in vorgegebener Stöchiometrie herstellt, und wobei man die Schmelze mit Temperaturen von 900 bis 1300°C in eine Gießzone einlaufen läßt, welche in Abhängigkeit von ihrer lichten Weite mit 200 bis 1500 Upm um ihre Achse rotiert, und wobei man das erstarrte Formteil aus der Gießzone entnimmt, und wobei man das Formteil 4 bis 150 Stunden bei 700 bis 900°C in sauerstoffenthaltender Atmosphäre tempert, dadurch gekennzeichnet, daß die Achse der rotierenden Gießzone um mindestens 15° gegenüber der Horizontalen geneigt ist.

2. Verfahren nach Anspruch 1, dadurch gekennzeichnet, daß die Achse um bis zu 90° gegenüber der Horizontalen geneigt ist.

3. Verfahren nach Anspruch 1, dadurch gekennzeichnet, daß die Achse um 20 bis 60° gegenüber der Horizontalen geneigt ist.

4. Verfahren nach mindestens einem der Ansprüche 1 bis 3, dadurch gekennzeichnet, daß die Gießzone eine Kokille mit zylindrischem Innenraum ist.

5. Verfahren nach mindestens einem der Ansprüche 1 bis 3, dadurch gekennzeichnet, daß die Gießzone eine Kokille mit konusförmigem Innenraum ist.

6. Verfahren nach Anspruch 1, dadurch gekennzeichnet, daß größeren Neigungen der rotierenden Kokille gegenüber der Horizontalen größere Zahlen ihrer Umdrehung zugeordnet sind und umgekehrt.

## Claims

1. A process for producing tubular moldings from high-temperature superconducting material based on oxides of bismuth, calcium, strontium, copper and optionally lead, which comprises preparing a homogeneous melt of the oxide mixture in a predefined stoichiometry, and causing the melt having temperatures from 900 to 1300°C to flow into a casting zone which, as a function of its internal diameter, rotates at from 200 to 1500 rpm about its axis, and taking the solidified molding from the casting zone and annealing the molding for from 4 to 150 hours at from 700 to 900°C in an oxygen-containing atmosphere, wherein the axis of the rotating casting zone is inclined by at least 15° with respect to the horizontal.

2. The process as claimed in claim 1, wherein the axis is inclined by up to 90° with respect to the horizontal.

3. The process as claimed in claim 1, wherein the axis is inclined by from 20 to 60° with respect to the horizontal.

4. The process as claimed in at least one of claims 1 to 3, wherein the casting zone is a permanent mold having a cylindrical interior.

5. The process as claimed in at least one of claims 1 to 3, wherein the casting zone is a permanent mold having a cone-shaped interior.

6. The process as claimed in claim 1, wherein larger inclinations of the rotating permanent mold with respect to the horizontal are associated with larger numbers of its revolution and vice versa.

## Revendications

1. Procédé pour fabriquer des pièces moulées tubulaires constituées en un matériau supraconducteur à haute température à la base d'oxydes de bismuth, calcium, strontium, cuivre et le cas échéant de plomb, dans lequel on produit une fonte homogène du mélange d'oxydes sous une stoechiométrie prédéterminée, et on fait couler la fonte à des températures de 900 à 1300°C dans une zone de coulée qui est en rotation autour de son axe à 200 à 1500 tpm en fonction de sa largeur intérieure, et on enlève la pièce moulée solidifiée hors de la zone de coulée, et on fait tempérer la pièce moulée pendant 4 à 150 heures à des températures de 700 à 900°C dans une atmosphère contenant de l'oxygène, caractérisé en ce que l'axe de la zone de coulée en rotation est incliné d'au moins 15° par rapport à l'horizontale.

2. Procédé selon la revendication 1, caractérisé en ce que l'axe est incliné jusqu'à 90° par rapport à l'horizontale.

3. Procédé selon la revendication 1, caractérisé en ce que l'axe est incliné de 20 à 60° par rapport à l'horizontale.

4. Procédé selon l'une quelconque au moins des revendications 1 à 3, caractérisé en ce que la zone de coulée est une coquille présentant une chambre intérieure cylindrique.

5. Procédé selon l'une quelconque au moins des revendications 1 à 3, caractérisé en ce que la zone de coulée est une coquille présentant une chambre intérieure conique.

6. Procédé selon la revendication 1, caractérisé en ce qu'on associe à des inclinaisons plus importantes de la coquille en rotation par rapport à l'horizontale des vitesses de rotation plus importantes de la coquille, et inversement.
